# DEMANDE DE BREVET EUROPEEN

(11) **EP 4 656 350 A1**
(43) Date de publication de la demande: **03.12.2025**
(21) Numéro de dépôt: 25177322.2
(22) Date de dépôt: 19.05.2025
(51) Int. Cl.: B29C 43/14, H01L 21/02, B32B 37/00, B32B 38/10, H01L 21/027, H01L 21/56

(54) **PROCÉDÉ D'ÉLABORATION D'UN FILM DE POLYMÈRE ÉPAIS SUR UN SUBSTRAT**

(30) Priorité: 27.05.2024 FR 2405412
(71) Demandeur: Commissariat à l'Energie Atomique et aux Energies Alternatives, 75015 Paris (FR)
(72) Inventeur: MONTMEAT, Pierre, 38054 GRENOBLE CEDEX 09 (FR); FOURNEL, Franck, 38054 GRENOBLE CEDEX 09 (FR)
(74) Mandataire: Cabinet Beaumont

(57) **Abrégé**

La présente description concerne un procédé d'élaboration d'un film polymère à forte épaisseur sur un substrat (100) comprenant les étapes suivantes :
a) former un premier film polymère thermoplastique sur un premier substrat (100),
b) former un deuxième film polymère thermoplastique sur un deuxième substrat (200) comprenant un substrat support (210) recouvert par une couche antiadhésive (220),
c) coller le deuxième film polymère thermoplastique avec le premier film de polymère thermoplastique, par thermocompression, en appliquant une température de fluage supérieure à la température de transition vitreuse du premier film polymère thermoplastique et du deuxième film polymère thermoplastique, moyennant quoi on obtient un troisième film polymère thermoplastique (303),
d) séparer le premier substrat (100) du deuxième substrat (200), le troisième film polymère thermoplastique (303) se décollant de la couche antiadhésive (220) et restant collé sur le premier substrat (100).

## Description

### Domaine technique

La présente description concerne de façon générale les procédés d'élaboration de films polymères épais, notamment pour la microélectronique. Les films polymères épais sont particulièrement intéressants pour la fabrication de composants électroniques, notamment, lorsqu'il s'agit de procédés comprenant des étapes de photolithographie et/ou de collage.

### Technique antérieure

Les polymères utilisés pour la fabrication des composants électroniques sont généralement commercialisés sous forme de formulation liquide. Pour obtenir ainsi un film de polymère solide et continu, les formulations peuvent être étalées par enduction centrifuge sur le substrat, puis une étape de traitement thermique est ensuite réalisée pour éliminer le solvant.

La formulation est choisie en fonction du polymère et de la gamme d'épaisseur désirée. La gamme d'épaisseur dépend de la viscosité de la formulation liquide et de la vitesse de l'enduction centrifuge. Ces données sont fournies par le fabricant. Généralement, les films obtenus ont une épaisseur comprise entre une dizaine de nanomètres et plusieurs dizaines de micromètres, voire jusqu'à 100 µm pour certains polymères.

Cependant, certaines applications nécessitent de plus fortes épaisseurs de films polymères. Par exemple, pour assurer un collage sur une surface à fort relief, l'épaisseur du film doit être bien supérieure au relief du substrat de façon à bien l'encapsuler.

Pour obtenir de fortes épaisseurs, il semblerait envisageable d'utiliser une formulation très visqueuse et/ou de réduire la vitesse de centrifugation.

Néanmoins, sur des équipements automatiques industriels, une formulation très visqueuse nécessiterait des systèmes de pompage très performants et donc coûteux. De plus, les canalisations auraient tendance à s'obstruer très facilement. L'utilisation d'une faible vitesse de centrifugation conduirait, quant à elle, à une mauvaise homogénéité en épaisseur du film de polymère.

Par ailleurs, répéter plusieurs fois les étapes de dépôt de films polymères sur un même substrat conduirait à l'obtention d'une structure polymère inhomogène en épaisseur et dans laquelle le solvant aurait tendance à rester piégé aux différentes interfaces des films polymères.

### Résumé de l'invention

Il existe un besoin d'avoir un procédé d'élaboration d'un film polymère homogène de forte épaisseur.

Ce but est atteint par un procédé d'élaboration d'un film polymère à forte épaisseur sur un substrat comprenant les étapes suivantes :
a) former un premier film polymère thermoplastique sur un premier substrat,
b) former un deuxième film polymère thermoplastique sur un deuxième substrat, le deuxième substrat comprenant un substrat support recouvert par une couche antiadhésive,
c) coller le deuxième film polymère thermoplastique avec le premier film de polymère thermoplastique, par thermocompression, en appliquant une température de fluage supérieure à la température de transition vitreuse du premier film polymère thermoplastique et du deuxième film polymère thermoplastique, moyennant quoi on obtient un troisième film polymère thermoplastique,
d) séparer le premier substrat du deuxième substrat, le troisième film polymère thermoplastique se séparant de la couche antiadhésive et restant sur le premier substrat.

Selon un mode de réalisation particulier, les étapes b) à d) sont répétées une ou plusieurs fois jusqu'à obtenir un film polymère thermoplastique ayant l'épaisseur désirée.

Selon un mode de réalisation particulier, le premier film polymère thermoplastique et le deuxième film polymère thermoplastique sont choisis, indépendamment l'un de l'autre, parmi les films en polyoléfine, en polyamide, en poly(téréphtalate d'éthylène) ou en copolymère d'éthylène et d'acétate de vinyle.

Selon un mode de réalisation particulier, le premier substrat est recouvert par des éléments en relief, par exemple des puces ou des piliers, les éléments en relief ayant, de préférence, une épaisseur d'au moins 80µm et, encore plus préférentiellement, d'au moins 100µm d'épaisseur.

Selon un mode de réalisation particulier, le procédé comprend, après l'étape d), une étape ultérieure d'abrasion mécanique, éventuellement suivie d'une étape d'abrasion mécano-chimique, sur les éléments en relief.

Selon un mode de réalisation particulier, la couche antiadhésive est une couche de polymère halogéné, de préférence, une couche de polymère fluoré.

Selon un mode de réalisation particulier, la couche antiadhésive est une couche formée de composés silanes, de préférence des halogénosilanes, par exemple une couche d'octadécyltrichlorosilane ou une couche de perfluorodécyltrichlorosilane.

Selon un mode de réalisation particulier, le premier substrat et/ou le substrat support du deuxième substrat sont en verre ou en matériau semiconducteur, par exemple en silicium.

Selon un mode de réalisation particulier, la température de fluage est supérieure d'au moins 100°C à la température de transition vitreuse du premier film polymère thermoplastique et à la température de transition vitreuse du deuxième film polymère thermoplastique.

Selon un mode de réalisation particulier, d'une part, l'énergie d'adhérence entre la couche antiadhésive et le troisième film polymère thermoplastique est inférieure d'au moins 500 mJ/m² à l'énergie d'adhérence entre le premier film polymère thermoplastique et le deuxième film polymère thermoplastique et, d'autre part, l'énergie d'adhérence entre la couche antiadhésive et le troisième film polymère thermoplastique est inférieure d'au moins 500 mJ/m² à l'énergie d'adhérence entre le premier substrat et le troisième film polymère thermoplastique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D, la figure 1E, la figure 1F et la figure 1G représentent, de manière schématique, différentes étapes d'un procédé d'élaboration d'un film polymère, selon un mode de réalisation particulier de l'invention ;
la figure 2A, la figure 2B, la figure 2C, la figure 2D, la figure 2E, la figure 2F et la figure 2G représentent, de manière schématique, différentes étapes d'un procédé d'élaboration d'un film polymère, selon un autre mode de réalisation particulier de l'invention.

Les différents éléments ne sont pas nécessairement représentés à la même échelle afin de rendre les figures plus lisibles.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à une structure dans une position normale d'utilisation.

Sauf précision contraire, les expressions "environ", "approximativement", "sensiblement", et "de l'ordre de" signifient à 10 % ou à 10° près, de préférence à 5 % ou à 5° près.

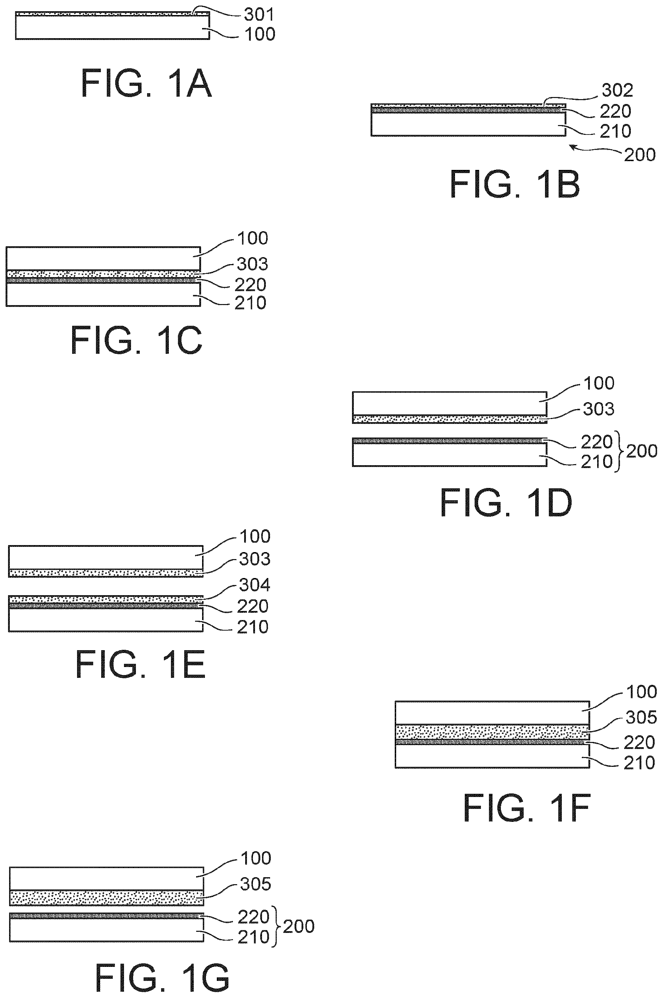

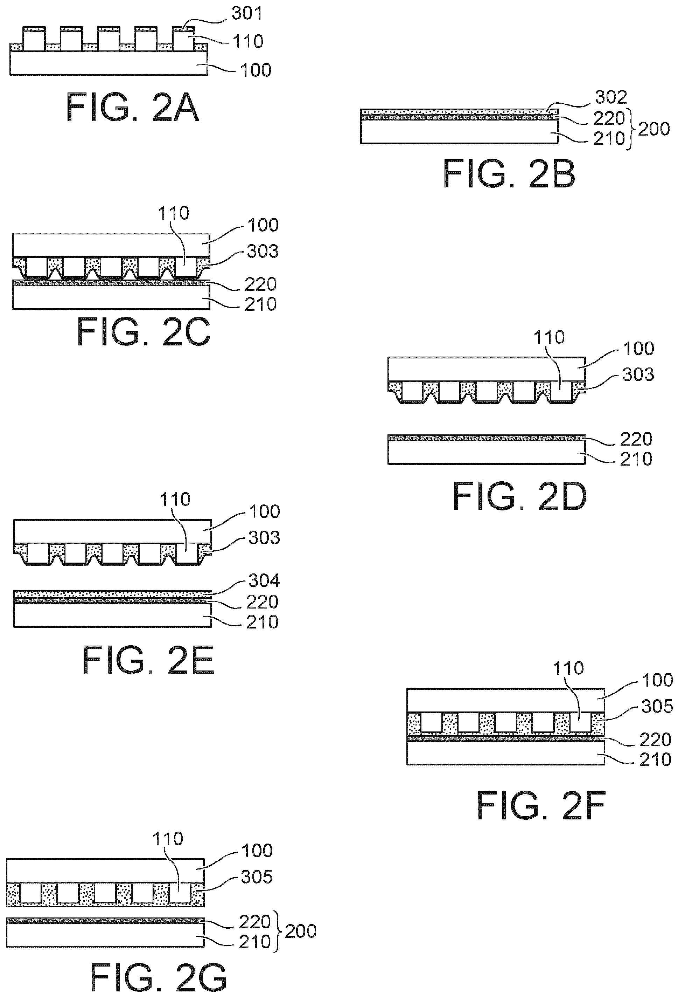

Nous allons maintenant décrire plus en détail le procédé d'élaboration d'un film polymère épais en faisant référence aux figures 1A à 1G et aux figures 2A à 2G.

Le procédé comprend au moins les étapes suivantes :
a) former un premier film polymère thermoplastique 301 sur un premier substrat 100, et plus particulièrement sur la face supérieure du premier substrat 100 (figures 1A, 2A),
b) former un deuxième film polymère thermoplastique 302 sur un deuxième substrat 200 comprenant un substrat support 210 recouvert par une couche antiadhésive 220 (figures 1B, 2B),
c) coller le deuxième film polymère thermoplastique 302 avec le premier film de polymère thermoplastique 301, par thermocompression, en appliquant une température de fluage supérieure à la température de transition vitreuse du premier film polymère thermoplastique 301 et du deuxième film polymère thermoplastique 302, moyennant quoi on obtient un troisième film polymère thermoplastique 303 (figures 1C, 2C),
d) séparer le premier substrat 100 du deuxième substrat 200, le troisième film polymère thermoplastique 303 se séparant du deuxième substrat 200 et restant sur le premier substrat 100 (figures 1D, 2D).

Le cycle d'étapes b), c) et d) peut être répété une ou plusieurs fois jusqu'à obtenir un film polymère 305 ayant l'épaisseur désiré (figures 1E à 1G et figures 2E à 2G).

Un film polymère homogène 303, 305 ayant une très forte épaisseur est ainsi formé.

Les films polymères obtenus 303, 305 sont des films épais. Par épais, on entend que l'épaisseur du film est supérieure à celle d'un film normalement formé dans les conditions de dépôt données par le fabricant. Par exemple, par épais on entend que l'épaisseur du film est au moins deux fois, voire trois fois supérieure à l'épaisseur du film donnée par le fabricant. L'épaisseur finale du film obtenu va dépendre du polymère et du nombre de films superposés. L'épaisseur des films obtenus est, par exemple, supérieure ou égale à 80µm voire supérieure ou égale à 120µm, c'est en particulier le cas pour les films en polyoléfine. L'épaisseur peut aller jusqu'à des valeurs supérieures à 400 µm voire 600 µm pour d'autres polymères.

Les paramètres d'étalement (vitesse de centrifugation) fournis par le fabricant peuvent être utilisés pour le dépôt de chaque film.

Le film polymère 303, 305 obtenu se différencie d'un élément multicouche par l'absence d'interface film/film ou film/solvant dans son volume. En effet, la mise en œuvre de l'étape de collage des films thermoplastiques à une température supérieure à leurs températures de fluage conduit à l'obtention d'un film polymère 303, 305 continu voire monobloc de plus forte épaisseur.

Le premier film polymère 301 et le deuxième film polymère 302 peuvent avoir des épaisseurs identiques ou différentes et/ou être en un même matériau ou en des matériaux différents. Ils sont, de préférence, identiques. Le premier film polymère 301 et le deuxième film polymère 302 peuvent comprendre un ou plusieurs polymères thermoplastiques.

Le premier film polymère thermoplastique 301 et/ou le deuxième film polymère thermoplastique 302 peuvent être choisis, indépendamment l'un de l'autre, parmi les polyoléfines (polyéthylène (PE) ou polypropylène (PP) par exemple), les polyamides (PA), les poly(téréphtalate d'éthylène) (PET) et les copolymères d'éthylène et d'acétate de vinyle (EVA).

Le premier film polymère 301 et le deuxième film polymère 303 peuvent être obtenus en déposant, par exemple par enduction centrifuge, une formulation liquide comprenant le ou les polymères thermoplastiques et un ou plusieurs solvants organiques sur la face supérieure du substrat d'intérêt 100 ou sur la couche adhésive 220 du deuxième substrat 200. Un traitement thermique peut être réalisé après chaque dépôt de film polymère pour éliminer le ou les solvants organiques. La température du traitement thermique sera choisie en fonction du solvant.

Des formulations liquides peuvent être des compositions commerciales BrewerBOND^{®} 305 commercialisé par Brewer Science ou Zero Newton TWM12000 Series commercialisé par TOKYO OHKA KOGYO Co (TOK).

Le premier substrat 100 est le substrat d'intérêt, c'est-à-dire le substrat sur lequel on souhaite former le film polymère épais. Le film polymère est formé sur la face supérieure du premier substrat 100.

On précise que, par face supérieure du premier substrat 100 (ou première face du premier substrat 100), on entend la face qui sert de base de dépôt du film polymère thermoplastique 301 en opposition à la face dite inférieure (ou deuxième face) opposée à la face supérieure, qui ne fait l'objet d'aucun dépôt dans le cadre de ce procédé.

Selon une première variante de réalisation, par exemple représentée sur les figures 1A à 1G, le premier substrat 100 a une surface plane et n'est recouvert par aucun élément. Le premier film polymère 301 déposé est en contact avec la première face du premier substrat 100.

Selon une deuxième variante de réalisation, par exemple représentée sur les figures 2A à 2G, la première face du premier substrat 100 est recouverte par des éléments en relief 110. Les éléments en relief 110 sont, par exemple, des puces électroniques ou des piliers. Les éléments en relief 110 ont, de préférence, une épaisseur d'au moins 80µm et, de préférence, au moins 100µm d'épaisseur.

Les puces 110 peuvent être collées sur la première face du premier substrat 100 pour former une structure pavée. A titre illustratif, la structure pavée peut être formée d'un substrat en silicium de 700 µm d'épaisseur sur lequel ont été collées des puces d'une épaisseur semblable.

Les piliers 110 peuvent être formées par structuration du premier substrat 100, par exemple au moyen d'une étape de photolithographie suivie d'une gravure.

Le deuxième substrat 200 comprend un substrat support 210 recouvert par une couche antiadhésive 220. Le film polymère est déposé sur la couche antiadhésive 220.

Le premier substrat 100 et le substrat support 210 du deuxième substrat 200 peuvent être en un matériau semiconducteur, par exemple, du silicium, du germanium, par exemple un alliage silicium-germanium, ou encore un semiconducteur III-V. Il peut également s'agir d'un substrat de type silicium sur isolant (SOI pour 'silicon-on-insulator').

Le premier substrat 100 et le substrat support 210 du deuxième substrat 200 peuvent être en même matériau ou en des matériaux différents. De préférence, le premier substrat 100 et le substrat support 210 du deuxième substrat 200 sont des substrats en silicium.

Le premier substrat 100 et le substrat support 210 du deuxième substrat 200 peuvent peuvent présenter des dimensions identiques et, en particulier, avoir la même forme et/ou la même superficie.

Par exemple, le premier substrat 100 et/ou le substrat support 210 peuvent être des plaques circulaires, de préférence, en silicium présentant un diamètre, de préférence compris entre 100 et 300 mm, notamment 200 mm.

La couche antiadhésive 220 présente des propriétés antiadhésives, et notamment une très faible énergie de surface (typiquement inférieure à 20 mJ/m²). Elle joue le rôle d'antiadhésif vis-à-vis de l'adhérence du polymère thermoplastique sur le substrat 200.

La couche antiadhésive 220 peut en particulier être choisie parmi :
- une couche comprenant un ou plusieurs polymères halogénés, de préférence un ou plusieurs polymères fluorés, tel qu'un polymère issu de la polymérisation d'au moins un monomère fluoré, par exemple, un monomère acrylate fluoré ou un monomère éthylénique fluoré ;
- une couche en un ou plusieurs composés silanes greffés sur le substrat support 210 et, plus particulièrement, une couche obtenue par greffage d'un ou plusieurs composés halogénosilanes, par exemple, l'octadécyltrichlorosilane ou le perfluorodécyltrichlorosilane.

Lorsque le substrat support 210 est en silicium et que la couche antiadhésive 220 est formée à partir d'un ou plusieurs composés halogénosilanes, le ou les composés halogénosilanes vont réagir avec les groupes hydroxyles présents spontanément à la surface du substrat support 210 en silicium. Le ou les composés sont ainsi greffés de façon irréversible à la surface du substrat support 210 et apporte le caractère antiadhésif au deuxième substrat 200.

La couche antiadhésive 220 peut être formée selon les étapes suivantes :
- une opération de mise en contact de la face supérieure du substrat support 210 avec une composition liquide comprenant un ou plusieurs composés antiadhésifs et au moins un solvant organique, par exemple, par enduction centrifuge ;
- une opération de séchage pour faire évaporer le ou les solvants.

Lors de l'étape a), le premier film polymère thermoplastique 301 est formé sur la face supérieure du premier substrat 100 (figures 1A, 2A). Il est de préférence déposé par enduction centrifuge ('spin-coating').

Le premier film polymère thermoplastique 301 présente une épaisseur Ep1.

Lors de l'étape b), le deuxième film polymère thermoplastique 302 est formé sur le deuxième substrat 200, et plus particulièrement sur la couche antiadhésive 220. Il est de préférence déposé par enduction centrifuge ('spin-coating').

Les conditions de dépôt du deuxième film polymère 302 peuvent être identiques ou différentes des conditions de dépôt du premier film polymère 301.

Le deuxième film polymère 302 présente une épaisseur Ep2. Le caractère peu mouillant de la couche antiadhésive 220 peut conduire à un deuxième film de polymère 302 non homogène. Par exemple, des zones de démouillage peuvent être observées. Néanmoins, de telles inhomogénéités ne sont pas gênantes puisque lors de l'étape c), un fluage du polymère est réalisé.

Les épaisseurs Ep1 et Ep2 peuvent être identiques ou différentes.

Lors de l'étape c), le premier substrat 100 et le deuxième substrat 200 sont assemblés en collant le premier film polymère thermoplastique 301 et le deuxième film polymère thermoplastique 302 par thermocompression.

Cette étape est réalisée à une température suffisante et une pression suffisante pour permettre la jonction entre le premier film polymère thermoplastique 301 et le deuxième film polymère thermoplastique 302. La pression est, par exemple, comprise entre 6 et 50kN, de préférence entre 10 et 50 kN. En particulier, la température appliquée est avantageusement supérieure aux températures de transition vitreuse (dite Tg) du ou des polymères thermoplastiques 301, 302 et, plus spécifiquement, elle est supérieure d'au moins 100°C à la température de transition vitreuse la plus élevée. Sous pression et à une telle température, le ou les polymères thermoplastiques deviennent fluides, ils fluent et viennent créer un contact intime entre les deux interfaces de polymère. Le cas échéant, les inhomogénéités et les zones démouillées liées à l'étalement du polymère sur le deuxième substrat 200 sont corrigées. Ce fluage est notamment possible lorsque la viscosité de l'adhésif est inférieure à 10⁴ Pa.s. On forme ainsi un troisième film polymère 303, formé du premier film polymère thermoplastique 301 et du deuxième film polymère thermoplastique 302. Le troisième film polymère thermoplastique 303 présente une épaisseur homogène. Il a une épaisseur Ep3 telle que Ep3 = Ep1 + Ep2.

A l'issue de l'étape c) de collage par thermocompression, on obtient un ensemble comprenant le premier substrat 100 et le deuxième substrat 200 entre lesquels est interposé un film polymère thermoplastique épais 303. Le film polymère est en contact direct avec le premier substrat 100 et avec la couche antiadhésive 220 du deuxième substrat 200.

Les films polymères thermoplastiques ont un caractère adhésif. Ils adhèrent sur le premier substrat 100 ou sur un autre film de polymère thermoplastique mais présentent une faible adhérence sur la couche antiadhésive 220.

Ainsi, le film en polymère thermoplastique 303 présente une adhérence plus importante avec le premier substrat 100 qu'avec la couche antiadhésive 220 du deuxième substrat 200.

Cet assemblage obtenu à l'étape c) est donc composé de trois interfaces :
- une interface entre le premier film polymère 301 et le deuxième film de polymère 302,
- une interface entre le premier film polymère thermoplastique 301 et le premier substrat 100,
- une interface entre le deuxième film polymère thermoplastique 302 et la couche antiadhésive 220.

En se plaçant à une température supérieure à la température de transition vitreuse du premier film polymère 301 et du deuxième film polymère 302, on assure une continuité entre les deux films de polymères 301, 302, et on reconstruit un troisième film solide homogène 303. L'adhérence E(Pol) de cette interface est très forte. Il s'agit de l'énergie de cohésion du polymère si les films polymères 301 et 303 sont identiques.

L'interface entre le premier film polymère 301 et le premier substrat 100 est l'interface d'étalement du polymère. Son adhérence est forte E(S1), elle est généralement inférieure à E(Pol).

L'interface entre le deuxième film polymère 302 du deuxième substrat 200 présente une très faible adhérence E(S2). En particulier E(S2) < E(S1) - 500 mJ/m² et de même E(S2) < E(Pol) - 500 mJ/m². De préférence, la différence entre E(S2) et E(S1) et/ou la différence entre E(S2) et E(Pol) sont d'au moins 2 J/m², voire d'au moins 3 J/m², encore plus préférentiellement d'au moins 10 J/m².

Ceci permet une mise en œuvre aisée de la dernière étape du procédé, à savoir, l'étape d) de séparation du deuxième substrat 200 et du film polymère thermoplastique 303.

Ainsi, lors de l'étape d), lorsque l'on sépare le premier substrat 100 du deuxième substrat 200, par exemple en insérant un coin dans l'assemblage, l'interface présentant la plus faible adhérence s'ouvre. Il s'agit de l'interface entre la couche antiadhésive 220 du deuxième substrat 200 et le troisième film polymère 303. On sépare ainsi le troisième film polymère 303 du deuxième substrat 200. Le premier substrat 100 est ainsi recouvert d'un film polymère 303 épais. Le deuxième substrat 200, recouvert de la couche antiadhésive 220, peut être directement ré-utilisé dans un nouveau cycle.

Lors de l'étape d), les espaces entre les éléments en relief 110 recouvrant le premier substrat 100 sont remplis au moins partiellement, voire totalement, par le troisième film polymère thermoplastique 303.

Par exemple, comme représenté sur les figures 1E à 1G et sur les figures 2E à 2G, le procédé peut comprendre, après l'étape d), les étapes suivantes :
- mettre en œuvre l'étape b) en formant un quatrième film polymère thermoplastique 304 d'épaisseur Ep4 sur le deuxième substrat 200, et plus particulièrement sur la couche antiadhésive 220 (figures 1E et 2E),
- mettre en œuvre l'étape c), en collant le premier substrat 100 et le deuxième substrat 200 par thermocompression, moyennant quoi on forme un cinquième film polymère 305 d'épaisseur Ep5 = Ep3 + Ep4, entre les substrats 100, 200 (figures 1F et 2F),
- mettre en œuvre l'étape d) de démontage pour décoller le deuxième substrat 200 du cinquième film polymère 305 (figures 1G et 2G).

Le cycle peut être répété jusqu'à l'obtention d'un film polymère de l'épaisseur désirée, l'épaisseur du film augmentant à chaque cycle réalisé.

Il est également possible de déposer les films polymères thermoplastiques uniquement sur l'un du premier substrat 100 ou du deuxième substrat 200. Cette variante de réalisation est intéressante pour former un film épais sur un substrat 100 recouvert d'éléments en relief 110. Il est notamment possible de réaliser les étapes suivantes :
- fournir un premier substrat 100, de préférence, recouvert d'éléments en relief 110,
- déposer un premier film polymère 301 sur un deuxième substrat 200 comprenant un substrat support 210 recouvert par une couche antiadhésive 220,
- assembler par thermocompression, le premier substrat 100 et le deuxième substrat 200, en mettant en contact le premier substrat 100 et le premier film polymère 301,
- séparer le premier substrat 100 du deuxième substrat 200, moyennant quoi on obtient un premier substrat 100 dont la face supérieure est recouverte par le premier film polymère 301, comme indiqué dans l'étape a) précédemment décrite,
- mettre en œuvre une ou plusieurs fois le cycle d'étapes b), c) et d) précédemment décrites.

Les espaces entre les éléments en relief 110 recouvrant le premier substrat 100 sont ainsi remplis par un film polymère d'épaisseur homogène.

Ce procédé est particulièrement intéressant pour le remplissage de structures en relief, notamment des structures pavées (par exemple représentées sur les figures 2A à 2G). La très forte épaisseur des puces (supérieure à 100 µm) fait qu'il est impossible de combler l'espace inter-puces par un étalement classique de polymère. En utilisant le procédé, il est possible de combler cet espace progressivement en répétant le cycle d'étapes d'étalement, collage et démontage.

La structure obtenue peut ensuite être soumise à une étape d'abrasion mécanique, éventuellement suivie d'une étape d'abrasion mécano-chimique, par exemple, pour avoir l'ensemble des éléments en relief à la même hauteur. Ces étapes sont facilement réalisables puisque les espaces entre les puces sont remplis de polymère thermoplastique.

### Exemples illustratifs et non limitatifs

Les exemples suivants sont réalisés au moyen de plaques de silicium de 200 mm de diamètre. Les énergies de surface sont évaluées par la méthode d'Owens et Wendt (J. Appl. Polym. Sci 13 (1969), 1741-1747) à partir de trois liquides : eau, éthylène glycol et diiodométhane. Les adhérences sont mesurées par la méthode du clivage proposée par Maszara et al. (J. Appl. Phys. 64 (1 0), 1988).

### Exemple 1 :

On étale un premier film de polymère 301 commercialisé par la société Brewer Sciences sous la référence BrewerBOND^{®} BB305 sur une plaque de silicium 100. Le film 301 a une épaisseur de 40 µm.

On vient déposer sur une plaque de silicium 210 un film fluoré 200 à partir d'une solution commercialisée par NOVEC (3M) sous la référence EGC 1720 pour former le deuxième substrat 200. L'énergie de surface du film de EGC 1720 est de 11 mJ/m².

On étale un deuxième film polymère 302 d'adhésif polymère BrewerBOND^{®} BB305 de 40 µm d'épaisseur sur le deuxième substrat 200.

On colle les deux substrats 100, 200 l'un à l'autre à une température de 250°C et une force de 15 kN pour former un troisième film 303. L'adhérence de l'interface entre le troisième film 303 en BrewerBOND^{®} BB305 et le premier substrat 100 est de 2 J/m². L'adhérence entre le troisième film 303 en Brewer 305 et la couche antiadhésive 220 de EGC 1720 est de 0,2 J/m².

On insère un coin dans la structure obtenue et on démonte le deuxième substrat, le troisième film 303 Brewer 305 reste collé à la surface du premier substrat 100. On obtient un troisième film 303 de BrewerBOND^{®} BB305 de 80 µm à la surface du premier substrat 100.

On étale à nouveau un quatrième film de polymère 304 Brewer BB305 de 40 µm sur le deuxième substrat 200.

On colle les substrats 100, 200 à une température de 250°C et une force de 15 kN pour former un cinquième film 305.

On insère un coin dans la structure et on démonte le deuxième substrat 200, le film 305 Brewer BB305 reste à la surface du premier substrat 100. On obtient un film 305 de Brewer BB305 de 120 µm à la surface du premier substrat 100. La structure est ensuite collée à 210°C et une force de 6 kN à une plaque de silicium recouvertes par des plots en silicium de 80 µm de hauteur, de 10 x 10 mm² de surface et espacés de 5 mm. La structure collée ne présente pas de défaut.

### Exemple 2 :

On étale un premier film de polymère 301 de BrewerBOND^{®} BB305 de 40 µm d'épaisseur sur une plaque de silicium 100.

On vient déposer sur une plaque de silicium 210 un film antiadhésif d'octadécyltrichlorosilane (OTS commercialisé par Sigma-Aldrich) 220. Le dépôt est effectué à partir d'une solution d'OTS dans l'isooctane. Un deuxième substrat 200 est ainsi obtenu. L'énergie de surface du film d'OTS 220 est de 17 mJ/m².

On étale sur le deuxième substrat 200 un deuxième film d'adhésif polymère 302 BrewerBOND^{®} BB305 de 40 µm d'épaisseur. On colle les deux substrats 100, 200 à une température de 250°C et une force de 15 kN. On forme entre les deux substrats 100, 200 un troisième film 303. L'adhérence de l'interface entre le troisième film 303 en BrewerBOND^{®} BB305 et le premier substrat 100 est de 2 J/m². L'adhérence entre BrewerBOND^{®} BB305 et la couche antiadhésive 220 du deuxième substrat 200 est de 0,2 J/m².

On insère un coin dans la structure et on démonte le deuxième substrat 200, le troisième film 303 adhésif Brewer 305 reste à la surface du premier substrat 100. On obtient un film de Brewer 305 de 80 µm à la surface du premier substrat 100.

### Exemple 3 :

On étale sur une plaque 100 un premier film adhésif 301 Zero Newton TWM12000 de 100 µm d'épaisseur.

On vient déposer sur une plaque de silicium 210 un film de perfluorodecyltrichlorosilane (FDTS, commercialisé par Sigma-Aldrich) en solution dans l'isooctane pour former une couche antiadhésive 220. On obtient ainsi un deuxième substrat 200. L'énergie de surface du film de FDTS 220 est de 10 mJ/m².

On étale sur le deuxième substrat 200 un deuxième film adhésif 302 Zero Newton TWM12000 de 100 µm.

On colle les deux substrats 100, 200 à 240°C et une force de 20 kN, moyennant quoi on forme un troisième film 303 entre les deux substrats 100, 200. L'adhérence de l'interface entre le troisième film 303 TWM12000 et le premier substrat 100 est de 3000 mJ/m². L'adhérence entre le troisième film 303 TWM12000 et la couche antiadhésive 220 en FDTS du deuxième substrat 200 est de 900 mJ/m².

On insère un coin dans la structure et on démonte le deuxième substrat 200, l'adhésif 303 en TWM12000 reste à la surface du premier substrat 100. On obtient un troisième film de polymère 303 de 200 µm d'épaisseur.

En répétant encore les opérations d'étalement de TWM12000 sur le deuxième substrat 200, de collage sur le premier substrat 100 et de démontage du deuxième substrat 200 à 4 reprises, le premier substrat 100 est revêtu d'un film de Zero Newton TWM12000 de 600 µm d'épaisseur.

### Exemple 4 :

On prend un premier substrat 100 formé d'une plaque sur laquelle sont collées des puces 110 carrées de 3 mm de côté de 650 µm d'épaisseur. Les puces 110 sont espacées de 1 mm.

On forme un deuxième substrat 200 en déposant sur un substrat support 210 de silicium un film antiadhésif 220 de perfluorodecyltrichlorosilane (FDTS, commercialisé par Sigma-Aldrich) en solution dans l'isooctane. L'énergie de surface du film de FDTS 220 est de 10 mJ/m².

On étale sur le deuxième substrat 200 un deuxième film adhésif 302 en TOK TWM12000 de 100 µm d'épaisseur.

On colle le deuxième substrat 200 avec le premier substrat 100 à 240°C et une force de 20 kN. On obtient un troisième film adhésif 303. L'adhérence de l'interface entre le troisième film 303 en TWM12000 et le premier substrat est de 3000 mJ/m². L'adhérence entre le troisième film 303 en TWM12000 et la couche antiadhésive 220 de FDTS est de 900 mJ/m².

On insère un coin dans la structure et on démonte le deuxième substrat 200. Le troisième film adhésif 303 en TWM12000 reste à la surface du premier substrat 100. On obtient un film de polymère 303 d'environ 400 µm entre les puces car l'appui du collage guide le polymère dans les tranchées. Une dizaine de microns de polymère reste en surface des puces.

En répétant encore les opérations d'étalement de film polymère TWM12000 sur le deuxième substrat 200, de collage sur le premier substrat 100 et de démontage du deuxième substrat 200, les tranchées entre les puces recouvrant le premier substrat 100 sont remplies de polymère.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Procédé d'élaboration d'un film polymère à forte épaisseur sur un substrat (100) comprenant les étapes suivantes :
a) former un premier film polymère thermoplastique (301) sur un premier substrat (100) recouvert par des éléments en relief (110),
b) former un deuxième film polymère thermoplastique (302) sur un deuxième substrat (200), le deuxième substrat (200) comprenant un substrat support (210) recouvert par une couche antiadhésive (220),
c) coller le deuxième film polymère thermoplastique (302) avec le premier film de polymère thermoplastique (301), par thermocompression, en appliquant une température de fluage supérieure à la température de transition vitreuse du premier film polymère thermoplastique (301) et du deuxième film polymère thermoplastique (302), moyennant quoi on obtient un troisième film polymère thermoplastique (303),
d) séparer le premier substrat (100) du deuxième substrat (200), le troisième film polymère thermoplastique (303) se séparant de la couche antiadhésive (220) et restant sur le premier substrat (100).

2. Procédé selon la revendication 1, dans lequel les étapes b) à d) sont répétées une ou plusieurs fois jusqu'à obtenir un film polymère thermoplastique ayant l'épaisseur désirée.

3. Procédé selon l'une des revendications 1 et 2, dans lequel le premier film polymère thermoplastique (301) et le deuxième film polymère thermoplastique (302) sont choisis, indépendamment l'un de l'autre, parmi les films en polyoléfine, en polyamide, en poly(téréphtalate d'éthylène) ou en copolymère d'éthylène et d'acétate de vinyle.

4. Procédé selon l'une des revendications précédentes, dans lequel les éléments en relief (110), par exemple des puces ou des piliers, ont une épaisseur d'au moins 80µm et, encore plus préférentiellement, d'au moins 100µm.

5. Procédé selon l'une des revendications précédentes, comprenant, après l'étape d), une étape ultérieure d'abrasion mécanique, éventuellement suivie d'une étape d'abrasion mécano-chimique, sur les éléments en relief (110).

6. Procédé selon l'une quelconque des revendications 1 à 5, dans lequel la couche antiadhésive (220) est une couche de polymère halogéné, de préférence, une couche de polymère fluoré.

7. Procédé selon l'une quelconque des revendications 1 à 5, dans lequel la couche antiadhésive (220) est une couche formée de composés silanes, de préférence des halogénosilanes, par exemple une couche d'octadécyltrichlorosilane ou une couche de perfluorodécyltrichlorosilane.

8. Procédé selon l'une quelconque des revendications précédentes, dans lequel le premier substrat (100) et/ou le substrat support (210) du deuxième substrat (200) sont en verre ou en matériau semiconducteur, par exemple en silicium.

9. Procédé selon l'une quelconque des revendications précédentes, dans lequel la température de fluage est supérieure d'au moins 100°C à la température de transition vitreuse du premier film polymère thermoplastique (301) et à la température de transition vitreuse du deuxième film polymère thermoplastique (302).

10. Procédé selon l'une quelconque des revendications précédentes, dans lequel, d'une part, l'énergie d'adhérence entre la couche antiadhésive (220) et le troisième film polymère thermoplastique (303) est inférieure d'au moins 500 mJ/m² à l'énergie d'adhérence entre le premier film polymère thermoplastique (301) et le deuxième film polymère thermoplastique (302) et, d'autre part, l'énergie d'adhérence entre la couche antiadhésive (220) et le troisième film polymère thermoplastique (303) est inférieure d'au moins 500 mJ/m² à l'énergie d'adhérence entre le premier substrat (100) et le troisième film polymère thermoplastique (303).

11. Procédé selon l'une quelconque des revendications précédentes, dans lequel, lors de l'étape d), les espaces entre les éléments en relief (110) recouvrant le premier substrat (100) sont remplis au moins partiellement, voire totalement, par le troisième film polymère thermoplastique (303).
